# EUROPÄISCHE PATENTSCHRIFT

(11) **EP 3 095 143 B1**
(45) Veröffentlichungstag und Bekanntmachung des Hinweises auf die Patenterteilung: **11.07.2018**
(21) Anmeldenummer: 14802626.3
(22) Anmeldetag: 20.11.2014
(51) Int. Cl.: H01L 35/30

(54) **SENSOR, SENSORSYSTEM UND VERFAHREN ZUM HERSTELLEN EINES SENSORS**
SENSOR, SENSOR SYSTEM AND METHOD FOR PRODUCING A SENSOR
CAPTEUR, SYSTÈME DE CAPTEURS ET PROCÉDÉ DE FABRICATION D'UN CAPTEUR

(30) Priorität: 13.01.2014 DE 102014200422
(43) Veröffentlichungstag der Anmeldung: 23.11.2016
(73) Patentinhaber: Robert Bosch GmbH, 70442 Stuttgart (DE)
(72) Erfinder: ZOLLER, Tobias, 72622 Nuertingen (DE); PIRK, Tjalf, 70195 Stuttgart (DE); KENNTNER, Johannes, 70825 Korntal-Muenchingen (DE); EHRENPFORDT, Ricardo, 70825 Korntal-Muenchingen (DE); ANTE, Frederik, 70197 Stuttgart (DE)
(86) Internationale Anmeldenummer: PCT/EP2014/075123
(87) Internationale Veröffentlichungsnummer: WO 2015/104085

(56) Entgegenhaltungen:
- WO-A1-2009/062635
- FR-A- 1 282 271
- US-A- 4 125 122

## Beschreibung

Die Erfindung betrifft einen Sensor, ein Sensorsystem und ein Verfahren zum Herstellen eines Sensors.

### Stand der Technik

Das Internet der Dinge wird als eine der wichtigsten zukünftigen Entwicklungen im Bereich der Informationstechnologie bezeichnet. Unter dem Internet der Dinge versteht man, dass nicht nur Menschen Zugang zum Internet haben und über dieses vernetzt sind, sondern dass auch Geräte über das Internet miteinander vernetzt sind. Ein Bereich des Internet der Dinge betrifft die Produktions- und Hausautomatisierung, z.B. zur Temperaturmessung. Diese Sensoren sind bereits verfügbar, weisen jedoch sehr hohe Herstellungskosten auf. Des Weiteren gehen Bestrebungen dahin, Sensoren zu entwickeln, die gleichzeitig die benötigte elektrische Energie aus der Umwelt gewinnen. Dies wird durch Photovoltaikzellen als auch durch thermoelektrische Generatoren, welche Energie aus einer Temperaturdifferenz gewinnen, ermöglicht.

Die gewonnene Energie eines thermoelektrischen Generators hängt direkt mit einem anliegenden Temperaturgradienten zusammen. Um den Temperaturgradient an einen thermoelektrischen Generator zu führen, muss mithilfe von Aufbau- und Verbindungstechnik ein Wärmepfad innerhalb eines Gehäuses des thermoelektrischen Generators hergestellt werden. Dieser Wärmepfad sollte im Idealfall einen niedrigen thermischen Widerstand aufweisen, um Verluste innerhalb des Gehäuses zu minimieren.

Die AT 0 190 151 B1 offenbart einen Spannungsgenerator mit thermoelektrischen Generatoren, die sich zwischen einer durch eine Abwärmequelle auf einer hohen Temperatur gehaltenen Zone und einer auf einer niedrigeren Temperatur liegenden, von mehreren in einem Kühlluftstrom angeordneten Rippen gebildeten Zone zur Erzeugung eines Temperaturgradienten erstrecken, wobei die Rippen länglich ausgebildet und in einer Gruppe mit im Wesentlichen parallelen Achsen angeordnet sind, wobei jede Rippe eine erste Längskante, die in direktem thermischen Kontakt mit der Abwärmequelle steht, aufweist. Somit entsteht in der Nähe der ersten Kante eine Hochtemperaturzone der Rippe. Ferner ist eine zweite Längskante gegenüber der ersten Kante im Abstand von der Abwärmequelle vorgesehen, wobei die zweiten Kanten der Rippen nicht umhüllte freie Kanten sind und die Gruppe der Rippen innerhalb eines Luftstroms angeordnet ist, sodass Kühlluft frei längs der Rippen strömen kann, sodass die Rippen gekühlt werden und eine Niedertemperaturzone der Rippe in der Nähe ihres zweiten Randbereichs entsteht, und dass die Generatoren aus mehreren Thermoelementen bestehen, die an jeder Rippe angebracht sind, wobei jedes Thermoelement eine Verbindung mit der Hochtemperaturzone der Rippe und eine Verbindung mit der Niedertemperaturzone der Rippe aufweist. WO2009/062635 offenbart ein Überwachungsvorrichtung mit einem integrierten thermoelektrischen Generator.

FR1282271 offenbart eine thermoelektrische Kühlvorrichtung, wobei ein Wandelement eine durch ein Mittel in das Wandelement eingeleitete Wärme auf eine Plattenvorrichtung überträgt.

US4125122 betrifft eine Vorrichtung zur direkten Umwandlung von Wärme in Elektrizität mittels einem integrierten System aus thermoelektrischen Elementen und Wärmerohren.

### Offenbarung der Erfindung

Die vorliegende Erfindung schafft einen Sensor, mit einem thermoelektrischen Generator zur Umwandlung von thermischer Energie in elektrische Energie, mit einer sich gegenüberliegenden Ober- und Unterseite, lateral zueinander versetzten Kontaktflächen zur Kontaktierung einer Heiß- und einer Kaltquelle, und thermischen Leiterpfaden, welche die Kontaktflächen mit der Ober- und Unterseite des thermoelektrischen Generators zur Bereitstellung eines thermischen Gradienten an Ober- und Unterseite des thermoelektrischen Generators verbinden, wobei der erste und/oder zweite thermische Leiterpfad derart ausgebildet ist, einen an den lateral zueinander versetzten Kontaktflächen anliegenden thermischen Gradienten zu der sich gegenüberliegenden Ober- und Unterseite des thermoelektrischen Generators umzulenken.

Die vorliegende Erfindung schafft des Weiteren ein Verfahren zum Herstellen eines Sensors, mit den Schritten Ausbilden eines auf einem Substrat angeordneten thermoelektrischen Generators zur Umwandlung thermischer Energie in elektrische Energie, mit einer sich gegenüberliegenden Ober- und Unterseite; Ausbilden von lateral zueinander versetzten Kontaktflächen zur Kontaktierung einer Heiß- und einer Kaltquelle; Ausbilden von thermischen Leiterpfaden, welche die Kontaktflächen mit der Ober- und Unterseite des thermoelektrischen Generators zur Bereitstellung eines thermischen Gradienten an Ober- und Unterseite des thermoelektrischen Generators verbinden, wobei der erste und/oder zweite thermische Leiterpfad einen an den lateral zueinander versetzten Kontaktflächen anliegenden thermischen Gradienten zu der sich gegenüberliegenden Ober- und Unterseite des thermoelektrischen Generators umlenken, wobei die Kontaktflächen durch ein Substrat voneinander getrennt sind und das Substrat eine geringere Wärmeleitfähigkeit als die Kontaktflächen aufweist. Die vorliegende Erfindung schafft überdies ein Sensorsystem mit dem erfindungsgemäßen Sensor, einer Leistungsschaltung zum Schalten einer durch den thermoelektrischen Generator erzeugten Spannung, einem Mikrocontroller zum Steuern des thermoelektrischen Generators, einem Energiespeicher zum Speichern der von dem thermoelektrischen Generator erzeugten Energie, einem Funkmodul zur drahtlosen Übertragung von Sensordaten, und einer Antenne.

### Vorteile der Erfindung

Ein Vorteil der vorliegenden Erfindung ist es, einen thermoelektrischen Generator vorzusehen, welcher mithilfe von Materialien des Standardverpackungsprozesses verpackbar ist und ein externer Temperaturgradient über Wärmeleitungspfade effizient zu Oberflächen des thermoelektrischen Generators geführt wird. Durch die Umlenkbarkeit des thermischen Gradienten innerhalb des Sensors mittels entsprechender Anordnung der thermischen Leiterpfade kann der Sensor derart ausgebildet sein, dass die Kontaktflächen zur Kontaktierung der Heiß- und der Kaltquelle an beliebigen Seiten des Sensors angeordnet werden können. Für den Fall, dass ein Temperaturgradient nicht durch eine vorgesehene Richtung des Gehäuses bzw. die Anordnung des thermoelektrischen Generators abfällt, können die Kontaktflächen zur Kontaktierung der Heiß- und der Kaltquelle entsprechend dem Temperaturgradienten angeordnet werden und der Temperaturgradient anschließend durch geeignete Anordnung der Wärmeleitungspfade zu den Oberflächen des thermoelektrischen Generators geführt werden.

Vorteilhafte Ausführungsformen und Weiterbildungen ergeben sich aus den Unteransprüchen sowie aus der Beschreibung unter Bezugnahme auf die Figuren.

Vorzugsweise ist vorgesehen, dass die Kontaktflächen durch ein Substrat voneinander getrennt sind und das Substrat eine geringere Wärmeleitfähigkeit als die Kontaktflächen aufweist. Durch die Trennung der Kontaktflächen durch das Substrat kann ein Temperaturgradient hergestellt werden, welcher somit der thermisch aktiven Ober- und der thermisch aktiven Unterseite des thermoelektrischen Generators zuführbar ist.

Vorzugsweise ist ferner vorgesehen, dass der Sensor relativ zu der Ober- und Unterseite des thermoelektrischen Generators benachbart und entfernt angeordnete Wandflächen sowie eine zu einer jeweiligen Seitenfläche des thermoelektrischen Generators benachbart angeordnete Seitenfläche aufweist, wobei zumindest eine der Kontaktflächen an einer, zur zu kontaktierenden Ober- oder Unterseite des thermoelektrischen Generators benachbart angeordneten Wandfläche des Sensors oder an einer Seitenfläche des Sensors angeordnet ist. Dadurch kann der Sensor an einen Temperaturgradienten einer Umgebung bzw. Einbaulage angepasst werden.

Gemäß einer weiteren bevorzugten Ausgestaltung ist vorgesehen, dass die thermischen Leiterpfade durch eine Vergussmasse eines Gehäuses oder an der Oberfläche der Vergussmasse oder auf der Oberfläche des Substrats angeordnet oder zumindest teilweise in das Substrat eingelassen und aus einem metallischen Material, vorzugsweise Kupfer ausgebildet sind. Dadurch kann eine kompakte Bauform des Sensors erreicht werden. Die Verwendung von Kupfer für die thermischen Leiterpfade ermöglicht eine gute Wärmeleitfähigkeit.

Vorzugsweise ist ferner vorgesehen, dass das Gehäuse aus der Vergussmasse, einem Deckel oder einer Leiterplatte ausgebildet ist, und/oder die Leiterpfade zur Oberseite des thermoelektrischen Generators zumindest einen Teil des Gehäuses ausbilden. Da die Vergussmasse eine geringere Wärmeleitfähigkeit als die thermischen Leiterpfade aufweist, kann der thermische Gradient effizient an die Ober- und Unterseite des thermoelektrischen Generators geführt werden. Für den Fall, in welchem die Leiterpfade zur Oberseite des thermoelektrischen Generators zumindest einen Teil des Gehäuses ausbilden, kann auf zumindest einen Teil des Gehäuses verzichtet werden.

Gemäß einem weiteren bevorzugten Ausführungsbeispiel ist vorgesehen, dass der thermische Leiterpfad zur Kontaktierung der Oberseite des thermoelektrischen Generators durch einen Metallbügel ausgebildet ist, welcher den thermoelektrischen Generator auf das Substrat drückt, wobei eine Befestigung des Metallbügels an der Oberseite des thermoelektrischen Generators durch ein thermisch leitfähiges Haftmittel ausgebildet ist. Dies stellt eine einfache und kostengünstige Ausgestaltung eines thermischen Leiterpfads zur Kontaktierung der Ober- oder Unterseite des thermoelektrischen Generators dar. Des Weiteren ist eine gesonderte Befestigung des thermoelektrischen Generators, wie beispielsweise durch Vorsehen einer Vergussmasse oder eines sonstigen Gehäuses, nicht erforderlich.

Gemäß einer weiteren bevorzugten Ausgestaltung ist vorgesehen, dass in dem Substrat oder den Kontaktflächen Durchgangslöcher zur Durchströmung der Gehäuseseiten mit einem Fluid ausgebildet sind, wobei der Fluidstrom eine thermische Verbindung zwischen dem Bereich in oder unter dem Substrat und einer Seite des thermoelektrischen Generators und/oder einem Leiterpfad (18, 20) herstellt. Die Durchgangslöcher zur Durchströmung der Gehäuseseiten können beispielsweise mit einem Zu- und Ablauf einer Heizung verbunden sein. Somit kann ein hoher Temperaturgradient erzeugt und an die Ober- und Unterseite des thermoelektrischen Generators zugeführt werden. Der thermoelektrische Generator weist somit einen verbesserten Wirkungsgrad auf.

Gemäß einer weiteren bevorzugten Ausgestaltung ist vorgesehen, dass in dem Gehäuse ein Hohlraum ausgebildet ist, wobei der Hohlraum mittels den in dem Substrat oder den Kontaktflächen ausgebildeten Durchgangslöchern mit einem Äußeren des Sensors verbunden ist, und wobei der Hohlraum und die Durchgangslöcher zur Durchströmung der Gehäuseseiten mit einem Fluid ausgebildet sind. Somit kann ebenfalls der Hohlraum mittels der Durchströmung mit einem Fluid genutzt werden, einen Temperaturgradienten zu steigern und dadurch ebenfalls den Wirkungsgrad des thermoelektrischen Generators zu steigern.

Die beschriebenen Ausgestaltungen und Weiterbildungen lassen sich beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

### Kurze Beschreibung der Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: eine Schnittansicht eines Sensors gemäß einer ersten Ausführungsform der Erfindung;
- Fig. 2: eine Schnittansicht des Sensors gemäß einer zweiten Ausführungsform der Erfindung;
- Fig. 3: eine Schnittansicht des Sensors gemäß einer dritten Ausführungsform der Erfindung;
- Fig. 4: eine Schnittansicht des Sensors gemäß einer vierten Ausführungsform der Erfindung;
- Fig. 5: eine Schnittansicht des Sensors gemäß einer fünften Ausführungsform der Erfindung;
- Fig. 6: eine Schnittansicht des Sensors gemäß einer sechsten Ausführungsform der Erfindung;
- Fig. 7: eine Schnittansicht des Sensors gemäß einer siebten Ausführungsform der Erfindung;
- Fig. 8: eine Schnittansicht des Sensors gemäß einer achten Ausführungsform der Erfindung;
- Fig. 9: eine Schnittansicht des Sensors gemäß einer neunten Ausführungsform der Erfindung; und
- Fig.10: ein Ablaufdiagramm eines Verfahrens zum Herstellen eines Sensors gemäß der ersten Ausführungsform der Erfindung.

In den Figuren der Zeichnung bezeichnen gleiche Bezugszeichen gleiche oder funktionsgleiche Elemente, Bauteile, Komponenten, soweit nichts Gegenteiliges angegeben ist.

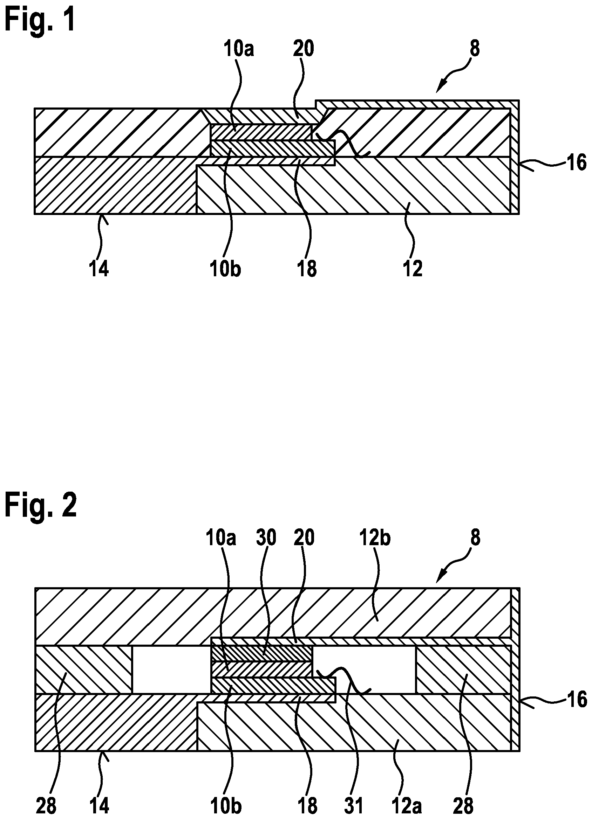

Fig. 1 zeigt eine Schnittansicht eines Sensors gemäß einer ersten Ausführungsform der Erfindung.

Der Sensor weist einen thermoelektrischen Generator 10 zur Umwandlung von thermischer Energie in elektrische Energie auf. Der thermoelektrische Generator 10 weist eine thermisch aktive Oberseite 10a und eine thermisch aktive Unterseite 10b auf. Des Weiteren weist der Sensor ein Paar von Kontaktflächen 14, 16 zur Kontaktierung einer Heiß- und einer Kaltquelle auf. Überdies weist der Sensor ein Paar von thermischen Leiterpfaden 18, 20 auf, welche die Kontaktflächen 14, 16 mit der Ober- und Unterseite 10a, 10b des thermoelektrischen Generators verbinden. Insbesondere ist eine erste Kontaktfläche 14 mittels eines ersten thermischen Leiterpfades 18 mit der Unterseite 10b des thermoelektrischen Generators 10 verbunden und eine zweite Kontaktfläche 16 mittels eines zweiten thermischen Leiterpfades 20 mit der Oberseite 10a des thermoelektrischen Generators 10 verbunden.

Der thermoelektrische Generator 10 ist ferner auf einem Substrat 12 angeordnet. Das Substrat 12 ist beispielsweise durch eine aus Silizium ausgebildete Leiterplatte vorgesehen. Alternativ kann das Substrat 12 auch aus einem duroplatischen Material, Glas oder Polyimid ausgebildet sein.

Das Substrat 12 weist eine geringere Wärmeleitfähigkeit als die Kontaktflächen 14, 16 sowie die thermischen Leiterpfade 18, 20 auf. Somit kann durch die Leiterpfade, 18, 20 ein thermischer Gradient effizient zu der Ober- und Unterseite des thermoelektrischen Generators 10 geführt werden.

Die erste Kontaktfläche 14 ist in der vorliegenden Ausführungsform in einem unteren Bereich des Sensors in einer gleichen horizontalen Ebene wie das Substrat 12 angeordnet. Der erste thermische Leiterpfad 18 erstreckt sich in horizontaler Richtung des Sensors von der ersten Kontaktfläche 14 zu der Unterseite 10b des thermoelektrischen Generators 10, wobei der erste thermische Leiterpfad 18 mit einer gesamten Oberfläche der Unterseite 10b des thermoelektrischen Generators 10 Kontakt bildet. Ferner ist der erste thermische Leiterpfad in das Substrat 12 eingelassen, sodass eine Oberkante der ersten Kontaktfläche 14 und eine Oberkante 12 bündig ausgebildet sind. Die zweite Kontaktfläche 16 ist im vorliegenden Ausführungsbeispiel an einer Seitenwand bzw. Seitenfläche des Sensors angeordnet. Der zweite thermische Leiterpfad 20 erstreckt sich von einer Oberkante der zweiten Kontaktfläche 16 in horizontaler Richtung des Sensors zu der Oberseite 10a des thermoelektrischen Generators 10, wobei der zweite thermische Leiterpfad 20 mit einer gesamten Oberfläche der Oberseite 10a des thermoelektrischen Generators 10 Kontakt bildet. Ein Gehäuse 8 des Sensors ist in vorliegendem Ausführungsbeispiel durch eine Vergussmasse ausgebildet, welche den thermoelektrischen Generator vollständig umgibt. Das Gehäuse zeichnet sich somit dadurch aus, dass der Temperaturgradient gleichermaßen vertikal und horizontal zum Gehäuse an den thermoelektrischen Generator geführt werden kann, um Energie zu gewinnen. Die Kontaktflächen 14, 16 sowie die thermischen Leiterpfade 18, 20 sind aus Kupfer ausgebildet, welches eine sehr gute Wärmeleitfähigkeit aufweist. Im vorliegenden Ausführungsbeispiel ist der erste thermische Leiterpfad 18 innenliegend und der zweite thermische Leiterpfad 20 außenliegend ausgeführt, um einen Wärmefluss zum thermoelektrischen Generator zuverlässig zu gewährleisten.

Vorzugsweise ist an der Unterseite 10b des thermoelektrischen Generators 10 eine (in Fig. 1 nicht gezeigte) Kontaktierung zur Ermöglichung einer verbesserten Wärmübertragung zum thermoelektrischen Generator 10 angeordnet. Optional kann ebenfalls an der Oberseite des thermoelektrischen Generators 10 eine (in Fig. 1 nicht gezeigte) Kontaktierung angeordnet sein.

Fig. 2 zeigt eine Schnittansicht des Sensors gemäß einer zweiten Ausführungsform der Erfindung.

Der Sensor ist in der vorliegenden Ausführungsform anstelle einer Vergussmasse zwischen zwei Leiterplatten eingehaust. Die Unterseite 10b des thermoelektrischen Generators 10 ist auf einem ersten Substrat 12a und die Oberseite 10a des thermoelektrischen Generators 10 benachbart zu einem zweiten Substrat 12b angeordnet, wobei das zweite Substrat 12b oberhalb des thermoelektrischen Generators 10 angeordnet ist.

Ferner weist der Sensor einen Abstandshalter 28 auf, welcher in einer horizontalen Ebene des Sensors zwischen dem ersten Substrat 12a und dem zweiten Substrat 12b angeordnet ist.

Insbesondere ist der Abstandshalter 28 zwischen der ersten Kontaktfläche 14 sowie dem ersten Substrat 12a an einer Unterseite des Abstandshalters 28 und dem zweiten Substrat 12b an einer Oberseite des Abstandshalters 28 angeordnet. Der Abstandshalter 28 ist vorzugsweise ringförmig ausgebildet. Alternativ kann der Abstandshalter 28 auch rahmenförmig ausgebildet sein bzw. eine andere geeignete Form aufweisen. Der Abstandshalter 28 weist ein haftvermittelnde Eigenschaft auf. Alternativ kann der Abstandshalter 28 auch mittels einer Löt- oder Klebeverbindung befestigt werden. Der Abstandshalter 28 ist vorzugsweise als Leiterplatte ausgebildet, wobei diese in einem mittigen Bereich ein Durchgangsloch aufweist. Alternativ kann der Abstandshalter 28 auch aus einem Prepreg Material ausgebildet sein. Weiterhin alternativ kann der Abstandshalter 28 beispielsweise durch eine in dem ersten Substrat 12a oder dem zweiten Substrat 12b ausgebildete Vertiefung vorgesehen sein.

Des Weiteren ist zwischen dem zweiten thermischen Leiterpfad 20 und der Oberseite 10a des thermoelektrischen Generators 10 eine Kontaktierung 30 angeordnet. Vorzugsweise ist an der Unterseite 10b des thermoelektrischen Generators 10 ebenfalls eine (in Fig. 2 nicht gezeigte) Kontaktierung angeordnet. Die jeweilige Kontaktierung ist vorzugsweise aus einem Klebstoff ausgebildet, welcher eine gut wärmeleitende Eigenschaft aufweist. Alternativ kann die Kontaktierung auch durch eine Lötverbindung ausgebildet sein. Durch Vorsehen der Kontaktierung kann eine Wärmeübertragung zum thermoelektrischen Generator 10 verbessert werden.

Ferner ist zwischen der Unterseite 10b des thermoelektrischen Generators 10 und dem Substrat 12a eine elektrische Kontaktierung 31 angeordnet, welche eine elektrische Verbindung herstellt. Die elektrische Kontaktierung 31 ist im vorliegenden Ausführungsbeispiel durch Bonddrähte ausgebildet.

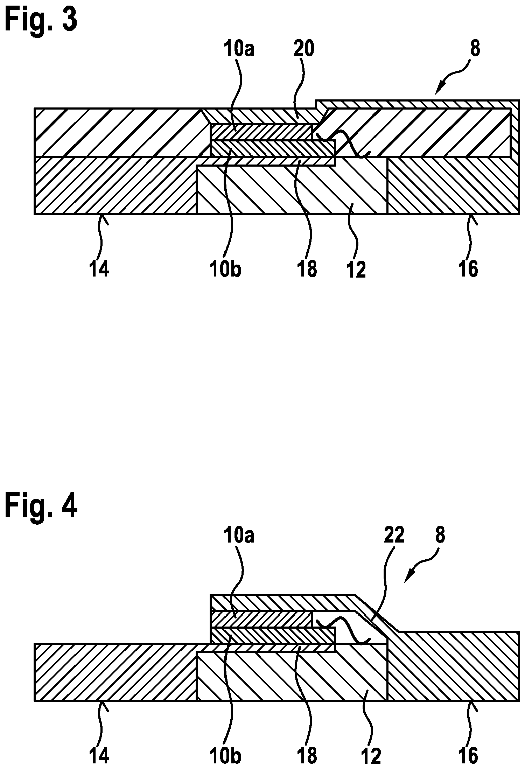

Fig. 3 zeigt eine Schnittansicht des Sensors gemäß einer dritten Ausführungsform der Erfindung.

Die erste Kontaktfläche 14 und die zweite Kontaktfläche 16 sind in der vorliegenden Ausführungsform auf der gleichen Seite, insbesondere der Unterseite des Sensors, angeordnet. Die Kontaktflächen 14, 16 weisen einen lateralen Abstand voneinander auf und sind durch das Substrat 12 voneinander getrennt. Das Substrat weist eine geringere Wärmeleitfähigkeit als die Kontaktflächen 14, 16 auf. Die zweite Kontaktfläche 16 ist mit dem zweiten thermischen Leiterpfad 20 verbunden, welcher wiederum mit der Oberseite 10a des thermoelektrischen Generators 10 verbunden ist. Die Temperatur der zweiten Kontaktfläche 16 und des zweiten thermischen Leiterpfades 20 wird somit außenliegend am Sensor bzw. Gehäuse 8 des Sensors der Oberseite 10a des thermoelektrischen Generators 10 zugeführt.

Vorzugsweise ist an der Unterseite 10b des thermoelektrischen Generators 10 eine (in Fig. 3 nicht gezeigte) Kontaktierung zur Ermöglichung einer verbesserten Wärmübertragung zum thermoelektrischen Generator 10 angeordnet. Optional kann ebenfalls an der Oberseite des thermoelektrischen Generators 10 eine (in Fig. 3 nicht gezeigte) Kontaktierung angeordnet sein.

Fig. 4 zeigt eine Schnittansicht des Sensors gemäß einer vierten Ausführungsform der Erfindung.

Der zweite thermische Leiterpfad, welcher ein Verbindungsglied zwischen der zweiten Kontaktfläche 16 und der Oberseite 10a des thermoelektrischen Generators 10 darstellt, ist in der vorliegenden Ausführungsform durch einen Metallbügel 22 ausgebildet. Der Metallbügel ist derart ausgebildet, dass dieser den thermoelektrischen Generator 10 auf das Substrat 12 drückt. Eine Befestigung des Metallbügels 22 an der Oberseite 10a des thermoelektrischen Generators 10 ist durch ein leitfähiges Haftmittel ausgebildet. Der Metallbügel 22 weist somit ebenfalls die Funktion des Gehäuses 8 auf. Ein zusätzlicher Deckel bzw. eine Vergussmasse zur Umschließung bzw. Fixierung des thermoelektrischen Generators 10 ist somit nicht vorgesehen. Als alternative Kontaktierung der Oberseite 10a des thermoelektrischen Generators 10 können z.B. auch Bonddrähte mit einer geeigneten thermischen Charakteristik verwendet werden. Ein in Fig. 4 nicht dargestellter Zwischenbereich zwischen dem Metallbügel 22 und der Oberseite 10a des thermoelektrischen Generators 10 sowie zwischen der Unterseite 10b des thermoelektrischen Generators 10 und dem ersten thermischen Leiterpfad 18 wird mit thermisch gut leitendem Kontaktmaterial wie z.B. Lötzinn, thermisch leitfähiger Klebstoff etc., realisiert.

Vorzugsweise ist an der Unterseite 10b des thermoelektrischen Generators 10 eine (in Fig. 4 nicht gezeigte) Kontaktierung zur Ermöglichung einer verbesserten Wärmübertragung zum thermoelektrischen Generator 10 angeordnet.

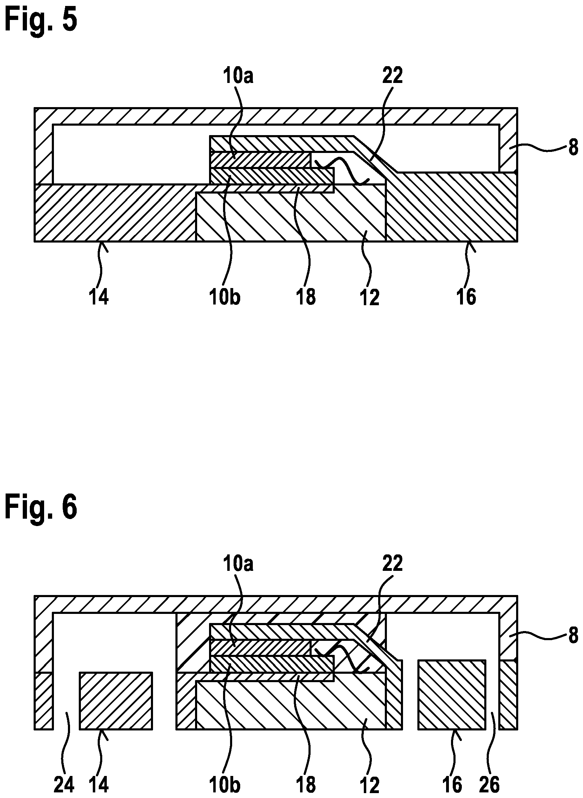

Fig. 5 zeigt eine Schnittansicht des Sensors gemäß einer fünften Ausführungsform der Erfindung.

Zusätzlich zu der in Fig. 4 gezeigten Ausführungsform weist der Sensor gemäß der Ausführungsform von Fig. 5 ein zusätzliches Gehäuse 8 in Form eines auf den jeweiligen Kontaktflächen 14, 16 aufgebrachten und den thermoelektrischen Generator 10 umschließenden Deckels auf. In dieser Ausführungsform wird eine temporäre Opferschicht, z.B. ein thermisch zersetzbares Polymer, als Platzhalter vor einem Formverfahren aufgebracht und nach dem Formverfahren durch einen weiteren Prozess zersetzt. Dieser weitere Prozess kann beispielsweise thermisch, nasschemisch oder trockenchemisch sein. Durch das Zersetzen entsteht ein Hohlraum, beispielsweise Luft, der thermisch schlecht leitend ist und somit den Wärmepfad durch den thermoelektrischen Generator 10 nur gering beeinflusst. Ein Gesamtsystem ist gegenüber Außeneinflüssen durch die Formmasse des Gehäuses 8 geschützt.

Vorzugsweise ist an der Unterseite 10b des thermoelektrischen Generators 10 eine (in Fig. 5 nicht gezeigte) Kontaktierung zur Ermöglichung einer verbesserten Wärmübertragung zum thermoelektrischen Generator 10 angeordnet.

Fig. 6 zeigt eine Schnittansicht des Sensors gemäß einer sechsten Ausführungsform der Erfindung.

Der Sensor weist gemäß der vorliegenden Ausführungsform ein erstes Durchgangsloch 24 sowie ein zweites Durchgangsloch 26 auf, wobei das erste Durchgangsloch 24 in der ersten Kontaktfläche 14 und das zweite Durchgangsloch 26 in der zweiten Kontaktfläche 16 ausgebildet sind. Die Durchgangslöcher 24, 26 dienen der Durchströmung der Gehäuseseiten mit einem Fluid, wobei ein Fluidstrom eine thermische Verbindung zwischen dem Bereich in oder unter den Kontaktflächen 14, 16 und einer Seite des thermoelektrischen Generators 10 herstellt. Die Durchgangslöcher 24, 26 verbinden des Weiteren einen in dem Gehäuse 8 ausgebildeten Hohlraum mit einem Äußeren des Sensors.

Vorzugsweise ist an der Unterseite 10b des thermoelektrischen Generators 10 eine (in Fig. 6 nicht gezeigte) Kontaktierung zur Ermöglichung einer verbesserten Wärmübertragung zum thermoelektrischen Generator 10 angeordnet.

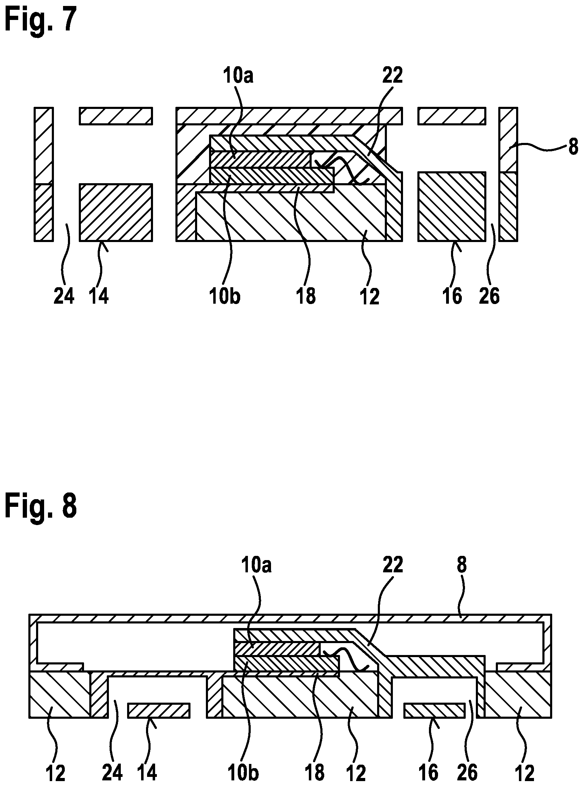

Fig. 7 zeigt eine Schnittansicht des Sensors gemäß einer siebten Ausführungsform der Erfindung.

Zusätzlich zu der in Fig. 6 dargestellten Ausführungsform ist gemäß der vorliegenden Ausführungsform das Gehäuse 8 des Sensors derart ausgebildet, dass dieses an den Seiten von einem Fluid komplett durchströmt wird. Beispielsweise kann ein Zu- und Ablauf einer Heizung angeschlossen werden. Der Temperaturgradient kann somit effizient an die Ober- und Unterseite 10a, 10b des thermoelektrischen Generators 10 geführt werden. Der Sensor kann somit an bereits vorhandene fluidische Systeme angekoppelt werden.

Vorzugsweise ist an der Unterseite 10b des thermoelektrischen Generators 10 eine (in Fig. 7 nicht gezeigte) Kontaktierung zur Ermöglichung einer verbesserten Wärmübertragung zum thermoelektrischen Generator 10 angeordnet.

Fig. 8 zeigt eine Schnittansicht des Sensors gemäß einer achten Ausführungsform der Erfindung.

Gemäß der vorliegenden Ausführungsform sind die Durchgangslöcher 24, 26 in den Kontaktflächen 14, 16 ausgebildet, wobei die Kontaktflächen 14, 16 in das Substrat 12 eingebettet sind. Die fluidischen Kontakte sind somit innerhalb des Substrats realisiert. Auf der Oberseite des thermoelektrischen Generators 10 ist ein Gehäuse 8 in Form eines Deckels vorgesehen. Alternativ kann auf der Oberseite des thermoelektrischen Generators 10 ebenfalls eine Kontaktierung oder eine Vergussmasse vorgesehen werden.

Vorzugsweise ist an der Unterseite 10b des thermoelektrischen Generators 10 eine (in Fig. 8 nicht gezeigte) Kontaktierung zur Ermöglichung einer verbesserten Wärmübertragung zum thermoelektrischen Generator 10 angeordnet.

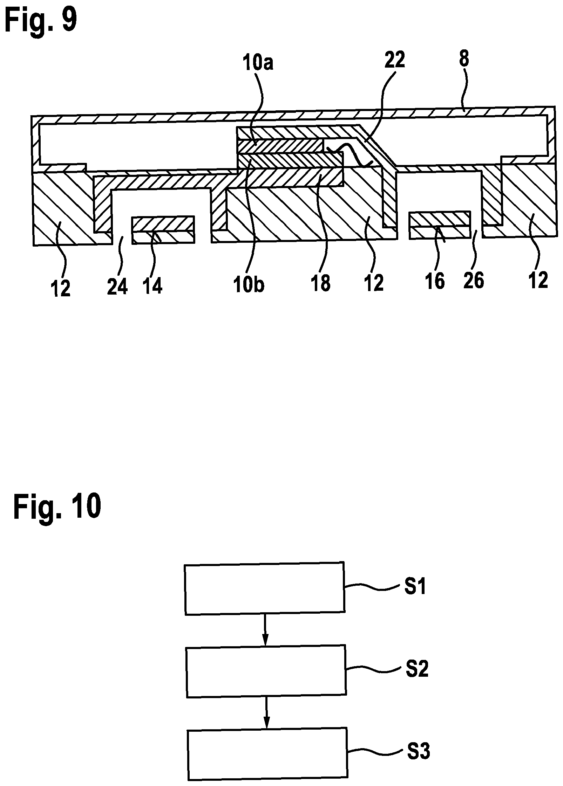

Fig. 9 zeigt eine Schnittansicht des Sensors gemäß einer neunten Ausführungsform der Erfindung.

Gemäß der vorliegenden Ausführungsform sind die Kontaktflächen 14, 16 jeweils in das Substrat 12 eingepresst. Die Durchgangslöcher 24, 26 sind wie in der mit Bezug auf Fig. 8 beschriebenen Ausführungsform in den Kontaktflächen 14, 16 ausgebildet. Vorzugsweise ist an der Unterseite 10b des thermoelektrischen Generators 10 eine (in Fig. 9 nicht gezeigte) Kontaktierung zur Ermöglichung einer verbesserten Wärmübertragung zum thermoelektrischen Generator 10 angeordnet.

Fig.10 zeigt ein Ablaufdiagramm eines Verfahrens zum Herstellen eines Sensors gemäß der ersten Ausführungsform der Erfindung.

In einem ersten Schritt S1 eines Verfahrens zum Herstellen eines Sensors erfolgt ein Ausbilden eines auf einem Substrat 12 angeordneten thermoelektrischen Generators 10 zur Umwandlung thermischer Energie in elektrische Energie, mit einer thermisch aktiven Ober- und Unterseite 10a, 10b. In einem zweiten Schritt S2 erfolgt ein Ausbilden von Kontaktflächen 14, 16 zur Kontaktierung einer Heiß- und einer Kaltquelle. In einem dritten Schritt S3 erfolgt ein Ausbilden von thermischen Leiterpfaden 18, 20, welche die Kontaktflächen 14, 16 mit der Ober- und Unterseite 10a, 10b des thermoelektrischen Generators 10 zur Erzeugung eines thermischen Gradienten zwischen der Ober- und Unterseite 10a, 10b des thermoelektrischen Generators 10 verbinden, wobei die thermischen Leiterpfade 18, 20 den thermischen Gradienten innerhalb des Gehäuses 8 umlenken. In einem vierten Schritt S4 erfolgt ein Ausbilden eines Gehäuses 8 zur Aufnahme des thermoelektrischen Generators 10.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Beispielsweise können sich die thermischen Leiterpfade 18, 20 aus metallischen Leiterbahnen, metallischen Durchkontakten, Drahtbonds, oder metallischen Klammern zusammensetzen.

## Patentansprüche

1. Sensor, mit einem thermoelektrischen Generator (10) zur Umwandlung von thermischer Energie in elektrische Energie, mit einer sich gegenüberliegenden Ober- und Unterseite (10a, 10b); lateral zueinander versetzten Kontaktflächen (14, 16) zur Kontaktierung einer Heiß- und einer Kaltquelle; und
thermischen Leiterpfaden (18, 20), welche die Kontaktflächen (14, 16) mit der Ober- und Unterseite (10a, 10b) des thermoelektrischen Generators (10) zur Bereitstellung eines thermischen Gradienten an Ober- und Unterseite (10a, 10b) des thermoelektrischen Generators (10) verbinden, **dadurch gekennzeichnet, dass** der erste und/oder zweite thermische Leiterpfad (18, 20) derart ausgebildet ist, einen an den lateral zueinander versetzten Kontaktflächen (14, 16) anliegenden thermischen Gradienten zu der sich gegenüberliegenden Ober- und Unterseite (10a, 10b) des thermoelektrischen Generators (10) umzulenken, wobei die Kontaktflächen (14, 16) durch das Substrat (12) voneinander getrennt sind und das Substrat (12) eine geringere Wärmeleitfähigkeit als die Kontaktflächen (14, 16) aufweist.

2. Sensor nach Anspruch 1, **dadurch gekennzeichnet, dass** der Sensor relativ zu der Ober- und Unterseite (10a, 10b) des thermoelektrischen Generators (10) benachbart und entfernt angeordnete Wandflächen sowie eine zu einer jeweiligen Seitenfläche des thermoelektrischen Generators (10) benachbart angeordnete Seitenfläche aufweist, wobei zumindest eine der Kontaktflächen (14, 16) an einer, zur zu kontaktierenden Ober- oder Unterseite (10a, 10b) des thermoelektrischen Generators (10) entfernt angeordneten Wandfläche des Sensors oder an einer Seitenfläche des Sensors angeordnet ist.

3. Sensor nach einem der vorhergehenden Ansprüche, **dadurch gekennzeichnet, dass** die thermischen Leiterpfade (18, 20) durch eine Vergussmasse eines Gehäuses (8) oder an der Oberfläche der Vergussmasse (12) oder auf der Oberfläche des Substrats angeordnet oder zumindest teilweise in das Substrat (12) eingelassen und aus einem metallischen Material, vorzugsweise Kupfer ausgebildet sind.

4. Sensor nach Anspruch 3, **dadurch gekennzeichnet, dass** das Gehäuse (8) aus der Vergussmasse, einem Deckel und/oder dem Substrat (12) ausgebildet ist, und/oder die Leiterpfade (18, 20) zur Oberseite (10a) des thermoelektrischen Generators (10) zumindest einen Teil des Gehäuses (8) ausbilden.

5. Sensor nach einem der vorhergehenden Ansprüche, **dadurch gekennzeichnet, dass** der thermische Leiterpfad zur Kontaktierung der Oberseite (10a) des thermoelektrischen Generators (10) durch einen Metallbügel (22) ausgebildet ist, welcher den thermoelektrischen Generator (10) auf das Substrat (12) drückt, wobei eine Befestigung des Metallbügels (22) an der Oberseite (10a) des thermoelektrischen Generators (10) durch ein thermisch leitfähiges Haftmittel ausgebildet ist.

6. Sensor nach einem der vorhergehenden Ansprüche, **dadurch gekennzeichnet, dass** in dem Substrat (12) oder den Kontaktflächen (14, 16) Durchgangslöcher (24, 26) zur Durchströmung der Gehäuseseiten mit einem Fluid ausgebildet sind, wobei der Fluidstrom eine thermische Verbindung zwischen dem Bereich in oder unter dem Substrat (12) und einer Seite des thermoelektrischen Generators (10) und/oder einem Leiterpfad (18, 20) herstellt.

7. Sensor nach Anspruch 6, **dadurch gekennzeichnet, dass** in dem Gehäuse (8) ein Hohlraum ausgebildet ist, wobei der Hohlraum mittels den in dem Substrat (12) oder den Kontaktflächen (14, 16) ausgebildeten Durchgangslöchern (24, 26) mit einem Äußern des Sensors verbunden ist, und wobei der Hohlraum und die Durchgangslöcher (24, 26) zur Durchströmung der Gehäuseseiten mit einem Fluid ausgebildet sind.

8. Verfahren zum Herstellen eines Sensors, mit den Schritten:
Ausbilden (S1) eines auf einem Substrat (12) angeordneten thermoelektrischen Generators (10) zur Umwandlung thermischer Energie in elektrische Energie, mit einer sich gegenüberliegenden Ober- und Unterseite (10a, 10b);
Ausbilden (S2) von lateral zueinander versetzten Kontaktflächen (14, 16) zur Kontaktierung einer Heiß- und einer Kaltquelle;
Ausbilden (S3) von thermischen Leiterpfaden (18, 20), welche die Kontaktflächen (14, 16) mit der Ober- und Unterseite (10a, 10b) des thermoelektrischen Generators (10) zur Bereitstellung eines thermischen Gradienten an Ober- und Unterseite (10a, 10b) des thermoelektrischen Generators (10) verbinden, **dadurch gekennzeichnet, dass** der erste und/oder zweite
thermische Leiterpfad (18, 20) einen an den lateral zueinander versetzten Kontaktflächen (14, 16) anliegenden thermischen Gradienten zu der sich gegenüberliegenden Ober- und Unterseite (10a, 10b) des thermoelektrischen Generators (10) umlenken, wobei die Kontaktflächen (14, 16) durch das Substrat (12) voneinander getrennt sind und das Substrat (12) eine geringere Wärmeleitfähigkeit als die Kontaktflächen (14, 16) aufweist.

9. Sensorsystem, mit einem Sensor nach einem der Ansprüche 1 bis 7;
einer Leistungsschaltung zum Schalten einer durch den thermoelektrischen Generator (10) erzeugten Spannung;
einem Mikrocontroller zum Steuern des thermoelektrischen Generators (10); einem Energiespeicher zum Speichern der von dem thermoelektrischen Generator (10) erzeugten Energie;
einem Funkmodul zur drahtlosen Übertragung von Sensordaten; und
einer Antenne.

## Claims

1. Sensor, comprising a thermoelectric generator (10) for converting thermal energy into electrical energy, comprising a mutually opposite upper and underside (10a, 10b); contact surfaces (14, 16) offset laterally relative to each other for making contact with a source of heat and cold; and thermal conductor paths (18, 20), which connect the contact surfaces (14, 16) to the upper and underside (10a, 10b) of the thermoelectric generator (10) in order to provide a thermal gradient on the upper and underside (10a, 10b) of the thermoelectric generator (10),
**characterized in that**
the first and/or second thermal conductive path (18, 20) is formed in such a way as to deflect a thermal gradient present on the contact surfaces (14, 16) that are offset laterally relative to each other to the opposite upper and underside (10a, 10b) of the thermoelectric generator (10), wherein the contact surfaces (14, 16) are separated from each other by the substrate (12), and the substrate (12) has a lower thermal conductivity than the contact surfaces (14, 16).

2. Sensor according to Claim 1, **characterized in that** the sensor has wall surfaces that are arranged adjacently and remotely relative to the upper and underside (10a, 10b) of the thermoelectric generator (10) and a side surface arranged adjacently to a respective side surface of the thermoelectric generator (10), wherein at least one of the contact surfaces (14, 16) is arranged on a wall surface of the sensor that is arranged remotely with respect to the contacting upper or underside (10a, 10b) of the thermoelectric generator (10) or on a side surface of the sensor.

3. Sensor according to one of the preceding claims, **characterized in that** the thermal conductor paths (18, 20) are arranged on a potting compound of a housing (8) or on the surface of the potting compound (12) or on the surface of the substrate or at least partly let into the substrate (12) and are formed from a metallic material, preferably copper.

4. Sensor according to Claim 3, **characterized in that** the housing (8) is formed from the potting compound, a cover and/or the substrate (12), and/or the conductor paths (18, 20) towards the upper side (10a) of the thermoelectric generator (10) form at least part of the housing (8).

5. Sensor according to one of the preceding claims, **characterized in that** the thermal conductor path for making contact with the upper side (10a) of the thermoelectric generator (10) is formed by a metal clip (22), which presses the thermoelectric generator (10) onto the substrate (12), wherein a fixing of the metal clip (22) to the surface (10a) of the thermoelectric generator (10) is formed by a thermally conductive contact adhesive.

6. Sensor according to one of the preceding claims, **characterized in that** passage holes (24, 26) for a fluid to flow through the housing sides are formed in the substrate (12) or the contact surfaces (14, 16), wherein the fluid flow produces a thermal connection between the region in or under the substrate (12) and a side of the thermoelectric generator (10) and/or a conductor path (18, 20).

7. Sensor according to Claim 6, **characterized in that** a cavity is formed in the housing (8), wherein the cavity is connected to an exterior of the sensor by means of passage holes (24, 26) formed in the substrate (12) or the contact surfaces (14, 16), and wherein the cavity and the passage holes (24, 26) are designed for a fluid to flow through the housing sides.

8. Method for producing a sensor, comprising the steps:
forming (S1) a thermoelectric generator (10), arranged on a substrate (12), for converting thermal energy into electrical energy, having a mutually opposite upper and underside (10a, 10b); forming (S2) contact surfaces (14, 16) offset laterally relative to each other for making contact with a source of heat and cold;
forming (S3) thermal conductor paths (18, 20), which connect the contact surfaces (14, 16) to the upper and underside (10a, 10b) of the thermoelectric generator (10) to provide a thermal gradient on the upper and underside (10a, 10b) of the thermoelectric generator (10);
**characterized in that** the first and/or second thermal conductor path (18, 20) deflect a thermal gradient present on the contact surfaces (14, 16) that are offset laterally relative to each other to the opposite upper and underside (10a, 10b) of the thermoelectric generator (10), wherein the contact surfaces (14, 16) are separated from each other by the substrate (12) and the substrate (12) has a lower thermal conductivity than the contact surfaces (14, 16).

9. Sensor system, comprising a sensor according to one of Claims 1 to 7;
a power circuit for switching a voltage generated by the thermoelectric generator (10):
a microcontroller for controlling the thermoelectric generator (10);
an energy store for storing the energy generated by the thermoelectric generator (10);
a radio module for the wire-free transmission of sensor data; and
an antenna.

## Revendications

1. Capteur, comportant un générateur thermoélectrique (10) servant à convertir l'énergie thermique en énergie électrique, comportant une face supérieure et une face inférieure (10a, 10b) en face l'une de l'autre ;
des surfaces de contact décalées latéralement (14, 16) servant à établir un contact avec une source chaude et une source froide ; et
des chemins de conduction thermique (18, 20) qui relient les surfaces de contact (14, 16) aux faces supérieure et inférieure (10a, 10b) du générateur thermoélectrique (10) afin de produire un gradient thermique sur les faces supérieure et inférieure (10a, 10b) du générateur thermoélectrique (10),
**caractérisé en ce que** le premier et/ou le second chemin de conduction thermique (18, 20) est réalisé de manière à dévier un gradient thermique appliqué aux surfaces de contact décalées latéralement l'une par rapport à l'autre (14, 16) vers les faces supérieure et inférieure en face l'une de l'autre (10a, 10b) du générateur thermoélectrique (10), dans lequel les surfaces de contact (14, 16) sont séparées l'une de l'autre par le substrat (12) et le substrat (12) présente une conductivité thermique inférieure à celle des surfaces de contact (14, 16).

2. Capteur selon la revendication 1, **caractérisé en ce que** le capteur présente des surfaces de paroi disposées de manière adjacente et éloignée par rapport aux faces supérieure et inférieure (10a, 10b) du générateur thermoélectrique (10) et une surface latérale disposée de manière adjacente à une surface latérale respective du générateur thermoélectrique (10), dans lequel au moins l'une des surfaces de contact (14, 16) est disposée sur une surface de paroi du capteur, avec laquelle un contact doit être établi, qui est disposée de manière éloignée des faces supérieure ou inférieure (10a, 10b) du générateur thermoélectrique (10), ou sur une surface latérale du capteur.

3. Capteur selon l'une des revendications précédentes, **caractérisé en ce que** les chemins de conduction thermique (18, 20) sont disposés à travers une masse coulée d'un boîtier (8) ou sur la surface de la masse coulée (12) ou sur la surface du substrat ou au moins partiellement incorporés dans le substrat (12) et **en ce qu'**ils sont réalisés à partir d'un matériau métallique, de préférence du cuivre.

4. Capteur selon la revendication 3, **caractérisé en ce que** le boîtier (8) est réalisé à partir de la masse coulée, d'un couvercle et/ou du substrat (12) et/ou **en ce que** les chemins de conduction (18, 20) forment au moins une partie du boîtier (8) vers la face supérieure (10a) du générateur thermoélectrique (10).

5. Capteur selon l'une des revendications précédentes, **caractérisé en ce que** le chemin de conduction thermique destiné à venir au contact de la face supérieure (10a) du générateur thermoélectrique (10) est formé par un étrier métallique (22) qui comprime le générateur thermoélectrique (10) sur le substrat (12), dans lequel une fixation de l'étrier métallique (22) sur la face supérieure (10a) du générateur thermoélectrique (10) est réalisée par un adhésif thermiquement conducteur.

6. Capteur selon l'une des revendications précédentes, **caractérisé en ce que** des trous traversants (24, 26) sont réalisés dans le substrat (12) ou les surfaces de contact (14, 16) de manière à ce qu'un fluide circule à travers les faces du boîtier, dans lequel l'écoulement de fluide établit une liaison thermique entre la région située dans ou sous le substrat (12) et une face du générateur thermoélectrique (10) et/ou un chemin de conduction (18, 20).

7. Capteur selon la revendication 6, **caractérisé en ce qu'**une cavité est formée dans le boîtier (8), dans lequel la cavité est reliée à l'extérieur du capteur au moyen des trous traversants (24, 26) réalisés dans le substrat (12) ou les surfaces de contact (14, 16), et dans lequel la cavité et les trous traversants (24, 26) sont réalisés de manière à ce qu'un fluide circule à travers les faces du boîtier.

8. Procédé de fabrication d'un capteur, comprenant les étapes consistant à :
réaliser (S1) un générateur thermoélectrique (10) disposé sur un substrat (12) pour convertir l'énergie thermique en énergie électrique, comportant des faces supérieure et inférieure (10a, 10b) en face l'une de l'autre ;
réaliser (S2) des surfaces de contact décalées latéralement l'une par rapport à l'autre (14, 16) pour établir un contact avec une source chaude et une source froide ;
réaliser (S3) des chemins de conduction thermique (18, 20) reliant les surfaces de contact (14, 16) aux faces supérieure et inférieure (10a, 10b) du générateur thermoélectrique (10) afin de produire un gradient thermique sur les faces supérieure et inférieure (10a, 10b) du générateur thermoélectrique (10), **caractérisé en ce que** le premier et/ou le second chemin de conduction thermique (18, 20) dévient un gradient thermique adjacent aux surfaces de contact décalées latéralement l'une par rapport à l'autre (10a, 10b) vers les faces supérieure et inférieure (10a, 10b) en face l'une de l'autre du générateur thermoélectrique (10), dans lequel les surfaces de contact (14, 16) sont séparées l'une de l'autre par le substrat (12) et le substrat (12) présente une conductivité thermique inférieure à celle des surfaces de contact (14, 16).

9. Système de capteur, comportant un capteur selon l'une des revendications 1 à 7 ;
un circuit de puissance servant à commuter une tension générée par le générateur thermoélectrique (10) ;
un microcontrôleur servant à commander le générateur thermoélectrique (10) ;
un accumulateur d'énergie servant à stocker l'énergie générée par le générateur thermoélectrique (10) ;
un module radio servant à la transmission sans fil de données de capteur ;
et une antenne.
